(19) Europäisches Patentamt
European Patent Office
Office européen des brevets

(11) **EP 2 641 869 A1**

(12) **EUROPEAN PATENT APPLICATION**
published in accordance with Art. 153(4) EPC

(43) Date of publication:
**25.09.2013 Bulletin 2013/39**

(51) Int Cl.:
***C01B 33/037*** (2006.01)

(21) Application number: **11841948.0**

(22) Date of filing: **15.11.2011**

(86) International application number:
**PCT/JP2011/076270**

(87) International publication number:
**WO 2012/067100 (24.05.2012 Gazette 2012/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.11.2010 JP 2010257212**

(71) Applicant: **Nippon Steel & Sumikin Materials Co.,
Ltd.**
**Chiyoda-ku**
**Tokyo 101-0021 (JP)**

(72) Inventors:
• **TANAKA, Masahiro**
  **Tokyo 100-8071 (JP)**
• **KISHIDA, Yutaka**
  **Tokyo 100-8071 (JP)**

(74) Representative: **Vossius & Partner**
**Siebertstrasse 4**
**81675 München (DE)**

(54) **METHOD AND DEVICE FOR SOLIDIFYING AND PURIFYING METALLIC SILICON**

(57)     Provided are a solidification purification method for a metallic silicon and a device therefor, which can more effectively and surely remove an impurity element than ever before while keeping the productivity of a crystal high. The solidification purification method for a metallic silicon, in which a melt of metallic silicon in a mold of a solidification purification device is subjected to unidirectional solidification to remove an impurity element in the metallic silicon, includes performing heating and/or cooling of the melt such that a compositional supercooling index $\{VOGC=(V/G)\times Cm\}$ expressed by using a temperature gradient G on a melt side of a solidification interface, a concentration Cm of the impurity element in the melt during the solidification, and a solidification velocity V maintains a relationship of $1/10\{0.59(D/m)\} \leq VOGC<0.59(D/m)$ with a critical value $\{0.59(D/m)\}$ of compositional supercoiling expressed by using a gradient m of a liquidus line read from a state diagram of silicon-impurity element in the metallic silicon and a diffusion coefficient D of the impurity element.

FIG. 1

**Description**

Technical Field

The present invention relates to a solidification purification method for a metallic silicon and a solidification purification device for a metallic silicon, and more particularly, to a solidification purification method for a metallic silicon and a device therefor, which are suitable for removing an impurity element from silicon in a molten state obtained by rough purification of the metallic silicon serving as a starting material, and finally obtaining a high-purity silicon crystal useful in production of a solar cell silicon substrate.

Background art

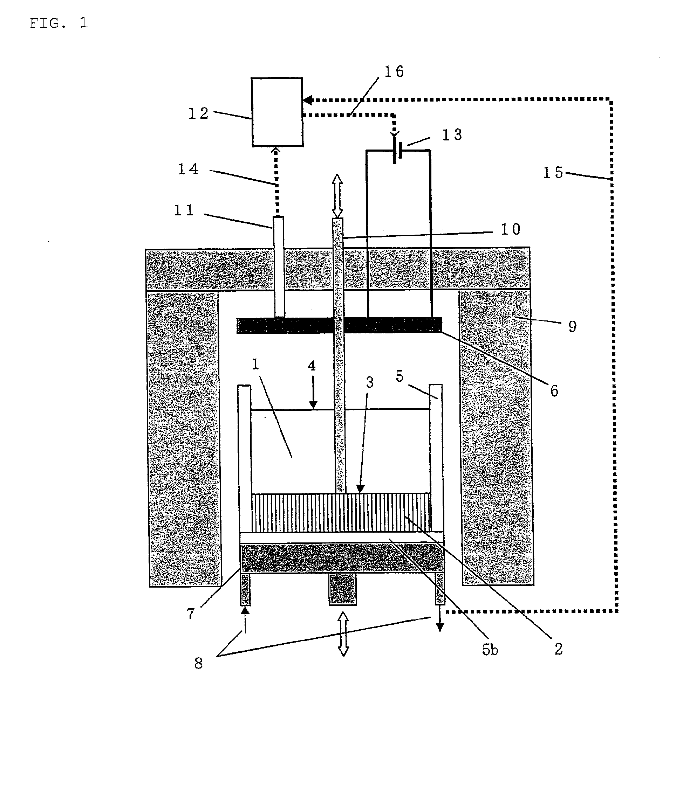

A solidification purification method is known as one of techniques for increasing the purity of metallic silicon, and is carried out, for example, in a furnace having a structure as illustrated in FIG. 1, based on a solidification purification principle as described below.

The solidification purification principle utilizes a segregation phenomenon due to a thermodynamic equilibrium state achieved by a purification target element and a removal target impurity element on a solidification interface (see Non Patent Literatures 1, 2, and 3). Specifically, when a molten raw material held in a mold, which is provided as a purification target, is gradually solidified in one direction (e.g., from the bottom to the upper side) while the solidification interface thereof is kept flat, during this solidification, the impurity element remains in the melt while hardly being incorporated into the solid by the segregation phenomenon. As a result, the distribution of the impurity element in the crystal generated by solidification is low at a lower part solidified at an initial stage and exponentially increases upward, thereby being significantly concentrated at the upper end of the crystal. The upper part (concentrated part) of the crystal obtained after the solidification purification is cut and discarded, and as a result, a high-purity crystal is obtained.

In actually performing such solidification purification, it is very important to control a solidification velocity (moving rate of the solidification interface) to a suitable value from two viewpoints, i. e. , productivity and purification yield. Further, this solidification velocity changes depending on a one-dimensional heat balance on the solidification interface, i.e., a balance among the quantity of heat added from the melt side to the solidification interface, the quantity of heat generated by the solidification (solidification latent heat), and the quantity of heat taken out from the solidification interface to the crystal side (see Non Patent Literature 1). Accordingly, when suitable temperature control is not performed, for example, solidification does not proceed successively from the lower part to the upper part, and a solidified portion melts again. As a result, there occurs a problem in that a crystal cannot be obtained from a melt even after a long period of time has passed.

In addition to the foregoing, when the suitable temperature control is not performed, the growth of a solidification interface becomes unstable, and the solidification does not proceed while maintaining a flat surface. As a result, there occurs another problem in that the segregation principle of an impurity element, which serves as a base of solidification purification, does not work well, the solidification is completed without sufficiently condensing the impurity element in the melt portion during the ongoing solidification, and thus an insufficiently solidified and purified crystal is produced.

Although the former problem is a problem of only a heat environment based on heating and/or cooling, the latter problem is a problem caused by a fact that equiaxial crystal is deposited in the melt, which is separated from the solidification interface, by compositional supercooling due to condensation of the impurity element in the melt, and as a result, solidification cannot successively advance while maintaining a columnar crystal structure to maintain its flat surface. Further, there is a theoretical model describing that "the generation of the equiaxial crystal by the compositional supercooling occurs when the value of the compositional supercooling [(V/G)C] (hereinafter referred to as compositional supercooling index (VOGC)) obtained by multiplying V/G, which is a ratio between a temperature gradient G and a solidification velocity V on the melt side of the solidification interface, by a concentration Cm of the condensed impurity element in the melt exceeds its critical value" (see Non Patent Literatures 1, 2, and 3). In this model, however, there is no description explaining the yield in an actual industrial process for purifying metallic silicon using the critical value of the compositional supercooling, and also the critical value of the compositional supercooling is not clear.

Thus, increasing the solidification velocity to achieve high productivity in solidification purification always promotes the risk of failure in the solidification purification. Further, in the second half of the proceeding of the solidification, the upper limit of the solidification velocity is gradually or rapidly decreased because a sudden increase in the concentration of the impurity element discharged by the segregation phenomenon occurs. Under such circumstances, for maintaining the productivity and purification yield of a crystal at the maximum, it is necessary that the solidification velocity, or alternatively the temperature environment in a mold, be precisely controlled depending on the concentration of the impurity element, which can be condensed depending on the progress status of the solidification, in the raw material melt in the mold. However, it is difficult to control the temperature environment. Hitherto, therefore, a trial- and-error method has been only employed.

For instance, the method described in Patent Literature 1 experientially determines the optimal solidification velocity by examining a correlation between an initial analytical value of the concentration of the impurity element in the raw material to be solidified and purified and an average solidification velocity from the start of the solidification to the completion thereof when the solidification purification is successfully performed. An adjustment of the optimal solidification velocity can be performed by adjusting the amount of cooling water or the temperature in cooling means placed on the bottom of a mold or adjusting the quantity of heat or the temperature of a heater placed on the upper part thereof. However, this method cannot fully respond to changes in the solidification velocity in complicated actual operation, the changes being resulted from factors, such as an increase in heat resistance of a solidification layer in progression of solidification, solidification latent heat generated in proportion to the solidification velocity, changes in heat conductivity and heat capacity due to long-term deterioration of a crystal or an insulation member in the furnace.

In addition, in order to overcome this problem, Patent Literature 2 proposes a method of adjusting the heat environment of the inside of a mold by estimating the solidification velocity by sequentially measuring the height of the solidification front (position of the solidification interface) according to the progression of the solidification using a plurality of thermometers and ultrasonic range finders provided in the mold. In this method, however, the solidification velocity of interest is determined by a trial-and-error procedure where relationships between the initial concentrations of various impurity elements in the raw material and the solidification velocity when the solidification purification is suitably performed is determined in advance from a large amount of operation data, and this is very complicated and time-consuming work. Further, such conventional method has a problem of equipment-based difficulty in installation of measuring devices, such as the thermometers and the ultrasonic range finders, in a high-temperature furnace, and also has a problem of difficulty in quick response to variations in operation, such as the degree of contact between the cooling means and the underside of the mold in each operation (the degree of contact influences the heat flow rate from the underside of the mold).

Citation List

Patent Literature

[PTL 1] JP 10- 120493 A
[PTL 2] JP 10- 182137 A

Non Patent Literature

[NPL 1] "Crystal Growth and Solidification" authored by Hideo Nakae, Agne Shofu Publishing Inc., 1998
[NPL 2] W. Kurz, D. J. Fisher, "Fundamental of Solidification, " Trans Tech Publication, (1998)
[NPL 3] M. C. Flemings, "Solidification Processing, " McGraw Hill, (1974)

Summary of Invention

Technical Problem

The present invention has been made in consideration of the above-mentioned circumstances and an object thereof is to provide a solidification purification method for a metallic silicon and a device therefor, which can more effectively and surely remove an impurity element than ever before while keeping the productivity of a crystal high, in particular a solidification purification method for a metallic silicon and a solidification purification device for a metallic silicon, which can quickly respond to influence of variations in degree of contact between cooling means and a lower part of a mold for holding a melt and influence of long-term deterioration of an insulation member in a furnace, and thus to provide a solidification purification method for a metallic silicon and a device therefor, which are suitable for obtaining a high-purity silicon crystal useful for the production of a solar cell silicon substrate.

Solution to Problem

The inventors of the present invention have intensively investigated for ways and means for achieving the object. As a result, the inventors of the present invention have arrived at the conclusion that, to achieve the object, a solidification velocity during solidification purification should not be initially set with reference to its relationship with the initial concentration of an impurity element but should be adjusted temporally with the progression of solidification. Then, to realize this idea, the inventors of the present invention have intensively studied for estimating the degree of compositional supercooling during the progression of solidification (compositional supercooling index: VOGC) and adjusting the degree of heating based on the estimated compositional supercooling index (VOGC). As a result, the present invention has been completed.

That is, the present invention has been made in order to solve the above-mentioned problem and is configured as described below.

(1) A solidification purification method for a metallic silicon, in which a melt of metallic silicon in a mold of a solidification purification device is subjected to unidirectional solidification to remove an impurity element in the metallic silicon, the method including performing heating and/or cooling of the melt such that a compositional supercooling index {VOGC= (V/G) ×Cm} expressed by using a temperature gradient G on a melt side of a solidification interface, a concentration Cm of the impurity element in the melt during the solidification, and a solidification velocity V maintains a relationship with a critical value {0.59 (D/m) } of compositional supercoiling expressed by using a gradient m of a liquidus line read from a state diagram of silicon- impurity element in the metallic silicon and a diffusion coefficient D of the impurity element, the relationship being expressed by the following expression.

$$1/10\{0.59(D/m)\} \leq VOGC < 0.59(D/m)$$

(2) A solidification purification method for a metallic silicon according to the above- mentioned item (1), in which the unidirectional solidification of the melt in the mold is carried out by radiant heating from above a liquid surface of the melt while insulating lateral sides of the mold, and cooling from a bottom of the mold by removal of heat.

(3) A solidification purification method for a metallic silicon according to the above- mentioned item (1) or (2), in which, based on: information about physical properties of the metallic silicon, which includes solidification latent heat, a solidification point, a density, and a thermal conductivity; initial information related to the melt before the solidification, which includes an initial concentration of the impurity element and an initial depth of the melt; and time- series information during the solidification, which includes a heat flow rate of removal of heat from a crystal to the outside and a height of a solidification front, the compositional supercooling index (VOGC) is given by calculating a product of the temperature gradient G on the melt side of the solidification interface and the solidification velocity V by using a balance of steady one- dimensional heat transfer through the solidification interface in a solidifying direction, and multiplying the product by the value Cm of the concentration of the impurity element in the melt.

(4) A solidification purification method for a metallic silicon according to the above- mentioned item (3), in which, based on: the information about physical properties of the metallic silicon, which includes L: solidification latent heat, $T_{mp}$: a solidification point of silicon, p: a crystal density at the solidification point, and $K_{mo}$: a thermal conductivity of the stationary melt; information about an effective thermal conductivity in the melt determined in advance, which includes Km: an effective thermal conductivity in the melt; the initial information related to the melt before the solidification, which includes $C_o$: an initial concentration of the impurity element and H: an initial depth of the melt; and the time- series information during the solidification, which includes $J_b$: a heat flow rate of removal of heat from a bottom of a container to the outside and x: a height of a solidification front, the compositional supercooling index (VOGC) is given by calculating the balance of steady one- dimensional heat transfer through the solidification interface in a solidifying direction by the following expression (1) :

$$VOGC = \frac{1}{\rho L}\left( J_b \frac{K_{m_0}}{K_m} \frac{K_m + (H-x)4\varepsilon\sigma T_a^3}{4\varepsilon\sigma T_a^3 (T_a - T_{mp})} - K_{m_0} \right) C_0 (1-x/H)^{keff-1}$$

$$\cdots\cdots (1)$$

where $T_a$ represents a radiation temperature of a heater, $\varepsilon$ represents an effective radiation rate between the melt surface and the heater, $\sigma$ represents a Stefan-Boltzmann constant, and $k_{eff}$ represents an effective distribution coefficient.

(5) A solidification purification device for a metallic silicon, which is configured to heat a melt of metallic silicon in a mold of the device by heat radiation from above a liquid surface of the melt, and cool the melt from a bottom of the mold by removal of heat, thereby carrying out unidirectional solidification of the melt in the mold to remove an impurity element in the metallic silicon, the device including:

heating means which includes a heater disposed above the liquid surface of the melt and configured to heat the liquid surface;
cooling means for cooling the bottom of the mold;
insulation means disposed on lateral sides of the mold and configured to insulate the lateral sides of the mold;
means for calculating a height of a solidification front, which is configured to calculate a solidification velocity V expressed by the following expression (0) from an initial stage of the solidification in chronological order,

$$V = \frac{1}{\rho L}\left(J_b - K_m \frac{4\varepsilon\sigma T_a^{\ 3}\left(T_a - T_i\right)}{K_m + (H - x)4\varepsilon\sigma T_a^{\ 3}}\right)$$

$$\cdots\cdots (0)$$

and calculate a time-series height x of the solidification front by accumulative calculationfrom the calculated time-series solidification velocity;
means for temperature measurement, which is configured to measure a radiation temperature $T_a$ of the heater in chronological order;
means for calculating a quantity of heat removed from the bottom, which is configured to measure an inlet temperature, outlet temperature, and flow rate of cooling water in the cooling means are measured in chronological order, and a heat flow rate $J_b$ removed from the bottom of the container to the outside is calculated from values obtained from the measurement;
means for computing a compositional supercooling index, into which information about physical properties of the metallic silicon, which includes L: solidification latent heat, $T_{mp}$: a solidification point of silicon, p: a density at the solidification point, and $K_{mo}$: thermal conductivity of the stationary melt, information about an effective thermal conductivity in the melt determined in advance, which includes Km: effective thermal conductivity in the melt, and initial information related to the melt before the solidification, which includes $C_o$: an initial concentration of the impurity element and H: an initial depth of the melt, are input, and also time-series information about the height x of the solidification front obtained by the means for calculating a height of a solidification front and time-series information about the heat flow rate $J_b$ removed from the bottom of the container to the outside, calculated by the means for calculating the quantity of heat removed from the bottom are input, and
which is configured to calculate a compositional supercooling index (VOGC) based on the input information by the following expression (1):
$$VOGC = \frac{1}{\rho L}\left(J_b \frac{K_{m_0}}{K_m} \frac{K_m + (H - x)4\varepsilon\sigma T_a^{\ 3}}{4\varepsilon\sigma T_a^{\ 3}\left(T_a - T_{mp}\right)} - K_{m_0}\right) C_0 \left(1 - x/H\right)^{keff-1}$$

$$\cdots\cdots (1)$$

[0024] ; and
means for controlling the radiation temperature of the heater, which is configured to adjust the radiation temperature of the heater depending on progress of the solidification of the melt so that the value of the compositional supercooling index (VOGC) calculated by the means for computing a compositional supercooling index maintains a relationship with a critical value {0.59 (D/m) } of compositional supercooling expressed by using a gradient m of a liquidus line, which is read from a state diagram of silicon- impurity element in the metallic silicon, and a diffusion coefficient D of the impurity element, the relationship being expressed as follows:

$$1/10\{0.59(D/m)\} \leq VOGC < 0.59(D/m).$$

(6) A solidification purification device for a metallic silicon according to the above- mentioned item 5, further including, instead of the means for calculating a height of a solidification front, means for measuring a height of a solidification front which is configured to measure the height of the solidification front in chronological order, in which, instead of the time- series information about the height of the solidification front obtained by the means for calculating a height of a solidification front, time- series information about the height of the solidification front obtained by the means for measuring a height of a solidification front is input into the means for computing a compositional supercooling index.

In the invention of the present application, the critical value of compositional supercooling that serves as an index for controlling the compositional supercooling index (VOGC) of a melt of metallic silicon is defined on the basis of the following relational expression obtained by mathematizing conditions, under which the compositional supercooling of the melt is generated, using a temperature gradient G on the melt side of a solidification interface, the concentration Cm of an impurity element in the melt during the solidification, a solidification velocity V, a gradient m of a liquidus line read from the state diagram of silicon-impurity element in metallic silicon, and a diffusion coefficient D of the impurity element:

$$(V/G)Cm>0.59(D/m)$$

(see the third chapter and Non Patent Literature 3 and the second chapter in the appendix thereof, and the second chapter of Non Patent Literature 2).

In other words, the conditions for generation of the compositional supercooling of a melt can be simply represented by $G<G_{mp}$ through the use of the gradient $G_{mp}$ (=$dT_{mp}/dx$) of the solidification point in the direction x of separating from the solidification interface and an actual temperature gradient G (=$dT/dx$). The gradient $G_{mp}$ of the solidification point can be represented by the product ($mG_c$) of the gradient $G_c$ of the concentration of the impurity element in the melt and the slope m of the liquidus line. In addition, the gradient $G_c$ of the concentration of the impurity element in the melt can be calculated by the following expression (2) on the basis of the diffusion coefficient D of the impurity element in the melt, the solidification velocity V, and the difference between the concentration $C_m{}^*$ of the impurity element in the melt on the solidification interface and the concentration $C_m$ of the impurity element in the major part of the melt sufficiently separated from the solidification interface.

$$G_c=(V/D)\times(C_m{}^*-C_m)\quad\cdots\cdots\quad(2)$$

Therefore, when the concentration of the impurity element on the solid side of the solidification interface is represented by $C_s$, an equilibrium distribution coefficient is represented by k, and an effective distribution coefficient is represented by $k_{eff}$, the expression can be rewritten as follows.

$$G_c=(V/D)\times\{(k_{eff}/k)-1\}C_m.$$

In addition, when the thickness of the diffusion layer of the solidification interface is represented by $\delta$, $k_{eff}/k$ can be represented by the following expression (3) .

$$k_{eff}/k=1/\{k+(1-k)\exp(-V\delta/D)\quad\cdots\cdots\quad(3)$$

In the solidification purification of metallic silicon according to the invention of the present application, the concentration distribution on the solidification interface may be formed by diffusion because of small influence of melt flow (i.e., because the diffusion coefficient D of the impurity is smaller than the kinematic viscosity coefficient of the melt) . Thus, the thickness $\delta$ of the diffusion layer is substantially approximated by $\delta$=D/v. Further, the value of $k_{eff}/k$ is approximated by 1/exp (- 1) $\approx$2.7 because the equilibrium distribution coefficient k of the impurity element in the metallic silicon used as a raw material is a value extremely smaller than 1.

Therefore, in the solidification purification of the metallic silicon of the invention of the present application, the concentration gradient of the melt can be represented by the following expression.

$$G_c = 1.7 (VC_m / D)$$

The conditional expression $G < G_{mp}$ of the compositional supercooling can be expressed by the following expression using the gradient m of the liquidus line, the concentration Cm of the impurity element in the melt, the dispersion coefficient D of the impurity element, and the solidification velocity V.

$$G < G_{mp} = mG_c = 1.7 (mVC_m / D)$$

When this expression is converted into the expression of a compositional supercooling index (VOGC), then the expression is given as follows.

$$(V/G) Cm > 0.59 (D/m)$$

Consequently, the conditions that allow the solidification purification to be carried out without generation of compositional supercooling are represented by the following expression where the inequality sign in the above-mentioned expression is reversed.

$$(V/G) Cm < 0.59 (D/m)$$

Further, the right-hand side "0.59 (D/m) " of the expression is the critical value of the compositional supercooling serving as the index of control.

Further, the gradient m of the liquidus line that defines the critical value of the compositional supercooling serving as the index of control using the compositional supercooling index (VOGC) in the solidification purification of metallic silicon of the invention of the present application can be read from the state diagram of silicon- impurity element in metallic silicon used as a raw material. In addition, as the diffusion coefficient D of the impurity element, the literature value described in a literature such as Tan et al., JOM vol. 61, no. 1, p 49 (2009) can be used. Alternatively, the coefficient can be estimated by a method using a numerical model of, for example, Liu et al., Scripta Materialia vol. 55 p 367, (2006) . Further, like the case of iron, when the diffusion coefficient D is not reported as experimental data and no reliable value is present, the critical value of VOGC can be directly calculated by statistical correspondence relationship between the position at which a crystal causes compositional supercooling and the VOGC value calculated using the expression (1) based on the operation data at such position in actual operation.

In the case where the melt contains two or more impurity elements, a decrease in solidification point of the melt is the sum of contributions of the respective impurities. Thus, when subscript "i" is added to each physical property of each impurity, the following expression (4) is obtained.

$$G_{mp} = \sum_i \left( 1.7 \times \frac{m_i V C_{mi}}{D_i} \right)$$

$$\cdots\cdots (4)$$

Here, when the total value of the concentrations of the respective impurities is defined as $C_{m\text{-all}}$ and the ratio of each impurity concentration to the total impurity concentration is defined as $\alpha_i$, the following expression (5) is obtained.

$$G_{mp} = 1.7 \times V \times C_{m-all} \sum_i \left( \frac{C_{mi}}{C_{m-all}} \frac{m_i}{D_i} \right)$$

$$= 1.7 \times V \times C_{m-all} \sum_i \left( \alpha_i \frac{m_i}{D_i} \right)$$

$$\cdots \cdots (5)$$

Therefore, the conditions $G_{mp}$>G that allow the solidification purification to be carried out can be written as follows.

$$(V/G) C_{m-all} < 0.59 < D/m >$$

In the expression, <D/ m> is the reciprocal of the weighted harmonic average of the values ($m_i/D_i$) of the respective impurity components taking $\alpha_i$ as a weight, and is defined by the following expression (6) .
$$\langle D/m \rangle = \frac{\sum_i \alpha_i}{\sum_i \left( \alpha_i \frac{m_i}{D_i} \right)} = \frac{1}{\sum_i \left( \alpha_i \frac{m_i}{D_i} \right)}$$

$$\cdots \cdots (6)$$

In the present invention, the melt is heated and/or cooled so that the compositional supercooling index {VOGC= (V/G) ×Cm} can maintain its relationship to the critical value {0.59 (D/m) } of the compositional supercooling as represented by the following expression:

$$1/10\{0.59 (D/m) \} \leq VOGC < 0.59 (D/m),$$

preferably

$$1/3\{0.59 (D/m) \} \leq VOGC < 0.59 (D/m).$$

The solidification velocity V is therefore kept high as much as possible, while a problem is prevented from occurring; the problem is that the compositional supercooling is generated by condensation of the impurity element in the melt during the process of solidification purification of metallic silicon, an equiaxial crystal is deposited in the melt separated from the solidification interface, and as a result, solidification cannot successively  progress while maintaining a columnar crystal structure to maintain its flat surface. Here, when the compositional supercooling index (VOGC) becomes the critical value {0.59 (D/m) } of the compositional supercooling or more, the generation of the compositional supercooling cannot be prevented. As a result, it becomes difficult to carry out the solidification purification while maintaining the flat surface. In contrast, when the index becomes less than 1/10 of the critical value {0.59 (D/m) } of the compositional supercooling, the productivity decreases because the solidification velocity V becomes too low.
In the present invention, the solidification purification device for a metallic silicon, which is used for solidification purification of metallic silicon, may be any device as long as it performs unidirectional solidification of a melt of metallic silicon to remove an impurity element in the metallic silicon. For example, the device may be one that performs unidirectional solidification of a melt in a mold upward from the bottom side thereof, or, on the contrary, one that performs unidirectional solidification from the upper side to the bottom side of the mold. For example, in the case of industrial production of a high-purity silicon crystal useful for the production of a solar cell silicon substrate, the unidirectional solidification of the melt in the mold is preferably one based on a system in which, while the lateral sides of the mold is insulated, heating is performed by heat radiation from above the liquid surface of the melt and simultaneously cooling is performed by removing heat from the bottom of the mold.

In the present invention, further, a method of controlling the heating and/or cooling of the melt is not specifically limited. For example, when the unidirectional solidification of the melt in the mold is carried out such that, while the lateral sides of the mold is insulated, heating is performed by heat radiation from above the liquid surface of the melt and simultaneously cooling is performed by removing heat from the bottom of the mold, the temperature of a heater placed above the liquid surface of the melt may be controlled, or cooling means such as a water-cooling jacket for heat removal disposed on the bottom of the mold may be controlled. Alternatively, both the heater temperature and the cooling means may be controlled.

Advantageous Effects of Invention

According to the present invention, in solidification purification of metallic silicon, the critical value {0.59 (D/m)} of compositional supercoiling is used as an index with respect to the melt of metallic silicon during solidification purification process. The melt is overheated and/or cooled while the compositional supercoiling index {VOGC= (V/G) ×Cm} is maintained so that it is within the range of 1/10 or more of the critical value and not more than the critical value. Thus, the solidification velocity can be temporally controlled with the progression of the solidification. This allows solidification purification to be performed at as high solidification velocity as possible without reducing the degree of purification of the impurity element. As a result, the productivity of a high- purity silicon crystal can be significantly improved. Moreover, according to the present invention, when carrying out solidification purification of metallic silicon by adopting the system in which, while the lateral sides of the mold is insulated, heating is performed by heat radiation from above the liquid surface of the melt and simultaneously cooling is performed by removing heat from the bottom of the mold, even when the degree of the contact between the cooling means and the underside of the mold holding a molten raw material changes for every operation to cause a change in the rate of heat flow out of the underside of the mold, the solidification velocity can be controlled according to such change. Thus, the optimization of the solidification velocity can be attained. Asa result, animprovement in silicon yield and a reduction in cost can be attained, and the production of an inexpensive solar cell silicon substrate becomes possible.

Brief Description of Drawings

FIG. 1 is a vertical cross-sectional explanatory diagram illustrating an example of a solidification purification device for a metallic silicon according to the present invention, the device being used for the production of a high-purity silicon crystal suitable for the production of a solar cell silicon substrate.

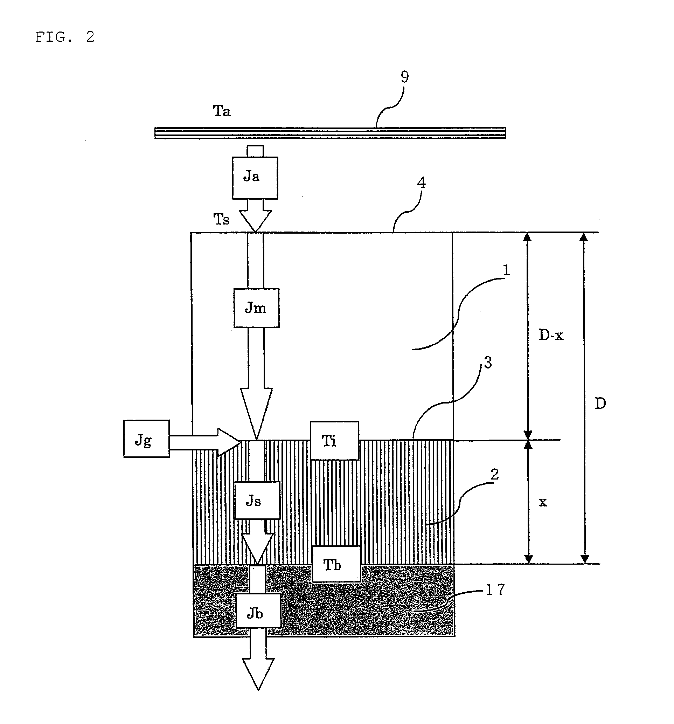

FIG. 2 is a conceptual diagram illustrating a solidification purification control model of the solidification purification device according to FIG. 1.

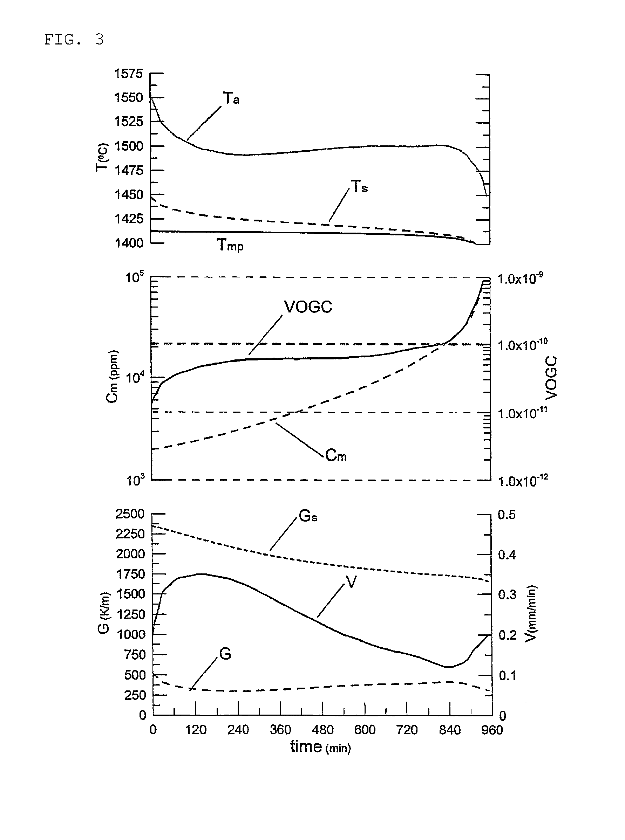

FIG. 3 is a graph showing an example set by calculating the value of a compositional supercooling index (VOGC) and then calculating the temperature of heater radiation so that the value of VOGC is equal to or less than the critical value of the compositional supercooling. FIG. 3 shows the temperature (°C) of heater radiation, the estimated temperature (°C) of the surface of the melt, and the change of the VOGC value relative to the solidification time (min.) . FIG. 3 also shows the concentration of an impurity (ppmw) in the melt, the gradient of temperature in the melt (K/m), and the gradient of temperature in the solid (K/m), which are required for calculation of the VOGC value.

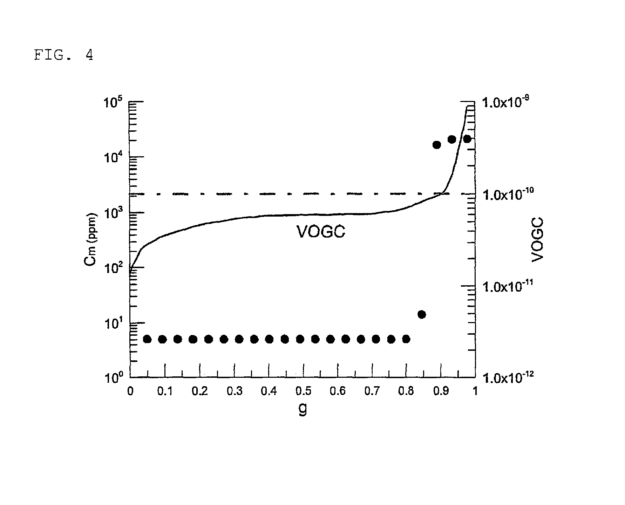

FIG. 4 is a diagram showing the relationship between the calculated VOGC value and the value of iron concentration in a crystal measured by a composition analyzer relative to the solidification rate of the obtained crystal in Example 1 of the present invention.

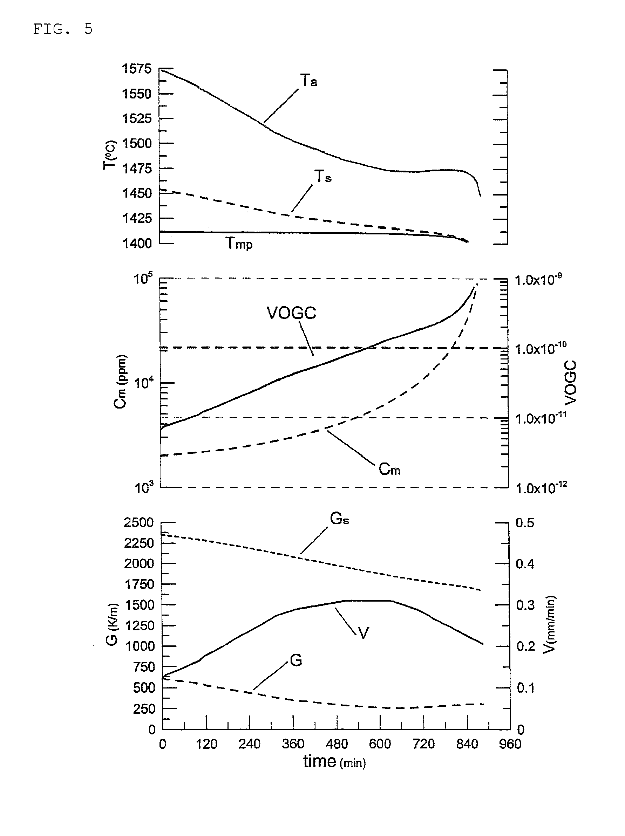

FIG. 5 is a graph showing a compositional supercooling index (VOGC) with predetermined temperature pattern of heater radiation in a comparative example of the present invention, where the temperature (°C) of heater radiation, the estimated temperature (°C) of the surface of the melt, and the change of the VOGC value relative to the solidification time (min.) are shown. FIG. 5 also shows the concentration of an impurity (ppmw) in the melt, the gradient of temperature in the melt (K/m), and the gradient of temperature in the solid (K/m), which are required for calculation of the VOGC value.

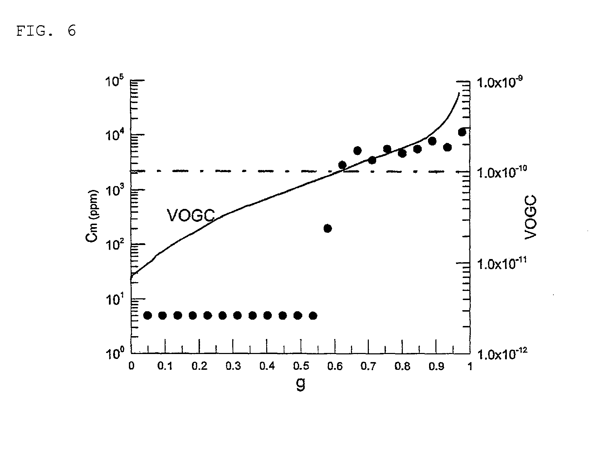

FIG. 6 is a diagram showing the relationship between the calculated VOGC value and the value of iron concentration in an ingot measured by a composition analyzer relative to the solidification rate of the obtained crystal in the comparative example of the present invention.

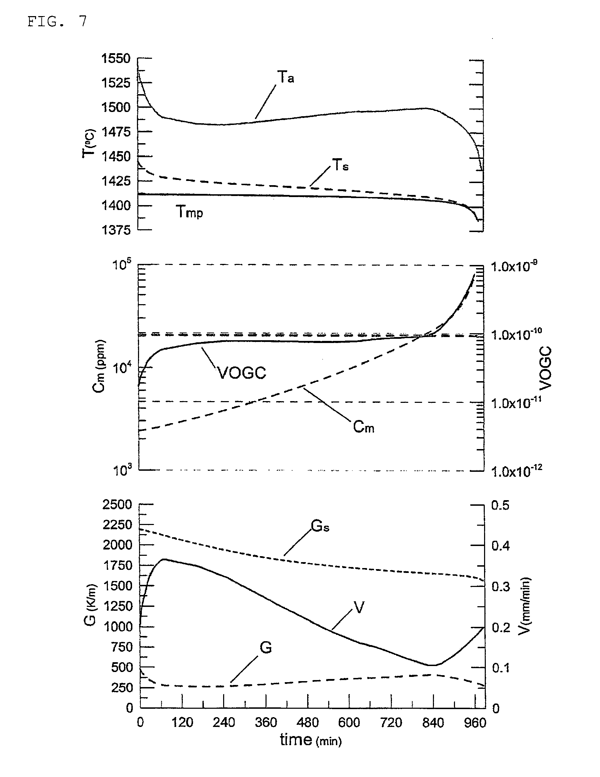

FIG. 7 is a graph showing a compositional supercooling index (VOGC) with predetermined temperature pattern of heater radiation in Example 2 of the present invention, where the temperature (°C) of heater radiation, the estimated temperature (°C) of the surface of the melt, and the change of the VOGC value relative to the solidification time (min.) are shown. FIG. 7 also shows the concentration of an impurity (ppmw) in the melt, the gradient of temperature in the melt (K/m), and the gradient of temperature in the solid (K/m), which are required for calculation of the VOGC value.

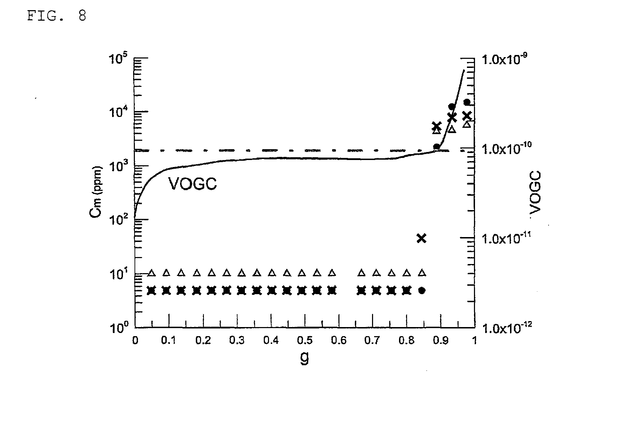

FIG. 8 is a diagram showing the relationship between the calculated VOGC value and the values of the respective concentrations of iron (Fe), aluminum (Al), and nickel (Ni) in an ingot measured by a composition analyzer relative to the solidification rate of the obtained crystal in Example 2 of the present invention.

Description of Embodiments

Hereinafter, an embodiment of the present invention is described using a solidification purification device for a metallic silicon as an example. The solidification purification device for a metallic silicon is configured for the production of a high purity silicon crystal suitable for the production of a solar cell silicon substrate, where solidification purification is carried out by performing unidirectional solidification of the melt in the mold such that, while the lateral sides of the mold is insulated by a heat insulating material, heating is performed by heat radiation of a heater from above the liquid level of the melt and simultaneously heat is removed from the bottom of the mold by cooling means such as a water-cooling jacket that performs cooling with cooling water.

In FIG. 1, a solidification purification device for a metallic silicon according to an example of the present invention is illustrated. In this FIG. 1, reference numeral 1 denotes a liquid phase (melt) of metallic silicon as a solidification purification raw material; 2 denotes a solid phase of the solidified and purified silicon; 3 denotes the solidification interface between the liquid phase and solid phase of the silicon; 4 denotes the surface of a melt of the liquid phase (melt) of the metallic silicon; 5 denotes a mold in which the metallic silicon as a solidification purification raw material is housed; 5b denotes the bottom of the mold 5; 6 denotes an electrical heater (heating means) arranged above the liquid level of the mold 5 and provided for radiant heating of the melt 1 from above the melt 1 in the mold 5; 7 denotes a water-cooling jacket (cooling means) arranged in contact with the bottom 5b of the mold 5; 8 denotes cooling water serving as a refrigerant and flowing through the inside of the water-cooling jacket 7 as cooling means; 9 denotes insulation means made of a heat insulating material that insulates the lateral sides of the mold 5; 10 denotes means for measuring the height of a solidification front, configured of, for example, a carbon rod or an ultrasonic analyzer for measuring the height of a solidification front (see M. Azizi, et al., "Ultrasound Measurement of the Position of the Growing Interface During Directional Solidification of Silicone" 25th EU-PVSEC proceedings, 2CV. 1. 13 (2010)); 11 denotes means for temperature measurement, provided for measuring the radiation temperature of the heating means 6, such as a thermocouple; 12 denotes means for controlling a solidification velocity, including means for calculating the quantity of heat removed from the bottom, where the quantity of heat removed from the bottom is calculated from information about the inlet temperature, outlet temperature, and flow rate of the cooling water in the water-cooling jacket, and means for compositional supercooling calculation, where a compositional supercooling index (VOGC) is calculated; 13 denotes a power source of the electrical heater 6 serving as heating means; 14 denotes transmission means for transmitting information about the radiation temperature of the heater to the means for compositional supercooling calculation of the means for controlling a solidification velocity; 15 denotes transmission means for transmitting information about the inlet temperature, outlet temperature, and flow rate of the cooling water to the means for compositional supercooling calculation of the means for controlling a solidification rate; and 16 denotes transmission means for transmitting power control information for the power source 13 of the electrical heater 6 from the means for calculating the quantity of heat removed from the bottom of the means for controlling a solidification rate to the power source 13 of the electrical heater 6, respectively.

In the method for solidification purification of the present invention, the melt (liquid phase) 1 of the metallic silicon in the molten state, which is poured into the mold 5, elevates the water-cooling jacket (cooling means) 7, which is initially placed so as to be separate from the lower surface of the bottom 5b of the mold 5, at the time of start of a solidification purification operation after the stabilization and maintenance a given melt, and the water-cooling jacket 7 is brought into contact with the lower surface of the bottom 5b of the mold 5 to cause a further decrease in radiation temperature of the heater. As a result, the solidification is gradually advanced from the bottom 5b side of the mold 5 to the upper side thereof.

In the solidification purification device for a metallic silicon of the present invention, the melt 1 of metallic silicon in the mold 5 is insulated in the lateral direction thereof by the heat insulating material (insulation means) 9 disposed on the lateral sides of the mold 5. In addition, the melt 1 is radiation-heated from above by the electrical heater (heating means) 6 arranged above the liquid surface of the melt 1. Further, the melt 1 is heat-removed by the water-cooling jacket (cooling means) 7 arranged on the bottom 5b of the mold 5. As a result, the heat flow rate passing from the upper side to lower side of the melt 1 in the mold 5 becomes large. The flow of heat, which flows from the liquid phase (melt) 1 to solid phase 2 of metallic silicon provided as a solidification purification raw material, becomes substantially one-dimensional in the vertical direction. Thus, the solidification of the liquid phase (melt) 1 advances from the bottom 5b side of the mold 5 to the upper side thereof while the solidification interface is kept as a single flat surface. In this case, further, it can be considered that the movement of heat in the inside of silicon is steady because it is sufficiently larger than the solidification velocity.

In the method of the present invention, from the start of solidification purification, the inlet temperature, outlet temperature, and flow rate of the cooling water 8 flowing through the cooling means 7 are measured. Then, the heat flow rate Jb passing from the bottom 5b side of the mold 5 to the lower side of the melt 1 in the mold 5, which is calculated from the water temperature difference between the inlet temperature and the outlet temperature, and the flow rate, and the temperature Ta of heater radiation are temporally recorded. Further, from those values and the initial concentration of the impurity element in the melt 1 of metallic silicon, which is previously measured before entry to the process, a steady one- dimensional heat transfer balance is calculated using a calculation model illustrated in FIG. 2. Thus, a temperature gradient G of the melt 1 side of the solidification interface 3 and the concentration of the impurity element in the melt 1 are temporally or intermittently calculated. The VC/G value of a compositional supercooling index (VOGC) is calculated using the information about the calculated temperature gradient G of the melt 1 side and the calculated concentration of the impurity element in the melt 1. The heater temperature $T_a$ and/or the heat flow rate $J_b$ are each/is controlled so that this VC/G value may maintain a relationship with a critical value {0.59 (D/m) } of compositional supercooling expressed by using the gradient m of a liquidus line, which is read from the state diagram of silicon- impurity element in metallic silicon of a solidification purification raw material, and the diffusion coefficient D of the impurity element, the relationship being expressed as follows:

$$1/10\{0.59(D/m)\} \leq VOGC < 0.59(D/m)$$

Therefore, the heating and/or cooling of the melt 1 can be optimally performed, and thus the maximum solidification velocity V not more than the critical value {0.59 (D/m) } of the compositional supercooling can be attained.

In other words, in FIG. 2, when a radiant heat flow rate from the heater to the surface of the melt is defined as $J_a$, a heat flow rate in the melt is defined as $J_m$, the quantity of solidification latent heat on the solidification interface in association with solidification is defined as Jg, a heat flow rate in the solid is defined as $J_s$, and a heat flow rate escaping from the lower part structure of the mold, such as the water-cooling jacket 7, through the bottom 5b of the mold 5, the rate being calculated from the inlet temperature, outlet temperature, and flow rate of the cooling water 8, is defined as $J_b$, then, since the heat flow is conserved, the one-dimensional heat balance of the system is represented as follows:

$$J_a = J_m \qquad \cdots\cdots (7)$$

$$J_m + J_g = J_s \qquad \cdots\cdots (8)$$

$$J_s = J_b \qquad \cdots\cdots (9)$$

Here, each heat flow has a relationship with the temperature of each part as follows:

$$J_a = \varepsilon\sigma(T_a^4 - T_s^4) \approx 4\varepsilon\sigma(T_a^4 - T_a^3 T_s) \qquad \cdots\cdots (10)$$

$$J_m = K_m(T_s - T_i)/(H-x) \qquad \cdots\cdots (11)$$

$$J_g = \rho LV \qquad \cdots\cdots (12)$$

$$J_s = K_s (T_i - T_b) / x \qquad \cdots\cdots (13)$$

Here, Ta is the radiation temperature of a heater, $T_s$ is a surface temperature of the melt, $T_i$ is the temperature of the solidification interface, $T_b$ is the temperature of the lower end portion of crystal, $\varepsilon$ is an effective radiation rate between the surface of the melt and the heater, $\sigma$ is the Stefan-Boltzmann constant, $K_m$ is an effective thermal conductivity in the melt, $K_s$ is a thermal conductivity in the crystal determined by physical properties, H is an initial depth of the melt, x is the height of the solidification front, p is the density of silicon at solidification temperature, L is a solidification latent heat determined by physical properties, and V is a solidification velocity. Here, the effective thermal conductivity in the melt depends on a device used because, in the case of agitating the melt with certain means, for example, the value changes with the degree of the agitation. Therefore, it is necessary to decide this value $K_m$ with actual measurement or an empirical formula. By eliminating the melt surface temperature $T_s$ from the expressions (7) to (12), the solidification velocity V is calculated as follows:

$$V = \frac{1}{\rho L} \left( J_b - K_m \frac{4\varepsilon\sigma T_a^{\ 3}(T_a - T_i)}{K_m + (H - x)4\varepsilon\sigma T_a^{\ 3}} \right)$$

$$\cdots\cdots (14)$$

From the expressions (7), (10), and (11), further, the temperature $T_s$ of the melt surface is given as follows:
$$T_s = \frac{4\varepsilon\sigma T_a^{\ 4} + K_m T_i / (H - x)}{4\varepsilon\sigma T_a^{\ 3} + K_m / (H - x)}$$

$$\cdots\cdots (15)$$

The thermal flux $J_m$ in the melt is given as follows by substituting the expression (15) into the expression (11):
$$J_m = \frac{4\varepsilon\sigma K_m T_a^{\ 3}(T_a - T_i)}{K_m + 4\varepsilon\sigma T_a^{\ 3}(H - x)}$$

$$\cdots\cdots (16)$$

The temperature gradient G on the melt side of the solidification interface is given as follows by using the thermal conductivity $Km_0$ in the stationary melt:
$$G = \frac{J_m}{K_{m_0}} = \frac{K_m}{K_{m_0}} \left( \frac{4\varepsilon\sigma T_a^{\ 3}(T_a - T_i)}{K_m + 4\varepsilon\sigma T_a^{\ 3}(H - x)} \right)$$

$$\cdots\cdots (17)$$

In the above expressions of V and G, values except x and $T_a$ are physical property values and actual measurement values, and hence V and G are given as functions of only the height x of the solidification front and the heater radiation temperature $T_a$. Therefore, the compositional supercooling index (VOGC) defined by an expression below is given as a function of only the height x of the solidification front and the heater radiation temperature $T_a$ because values except x and $T_a$ are physical property values and actual measurement values.

Further, in general, the solidification velocity of unidirectional solidification purification of Si is less than 1.0 mm/min. Thus, the degree of supercooling required as a driving force of crystal growth on the solidification interface is small, and hence the temperature Ti of the solidification interface may be considered as the solidification point $T_{mp}$ of the raw material Si.

Therefore, the VOGC is given by the following expression (18) :

$$VOGC = \frac{V}{G}C_m$$

$$= \frac{1}{\rho L}\left(J_b \frac{K_{m_0}}{K_m}\frac{K_m + (H-x)4\varepsilon\sigma T_a^3}{4\varepsilon\sigma T_a^3(T_a - T_{mp})} - K_{m_0}\right)C_0(1-x/H)^{keff-1}$$

$$\cdots\cdots (18)$$

However, in the metallic silicon provided as a raw material for solidification purification used in the present invention, the concentration of the impurity element is about 0.01 to 0. 5% by mass. Accordingly, in the purification of a low- purity raw material, such concentration of the impurity element cannot be neglected because the concentration $C_m$ of the impurity element concentrated in the melt when the solidification rate g of the solidification reaches 90% becomes about 5% by mass and a decrease in solidification point due to the impurity is estimated as several degrees Celsius.

Although the decrease in the solidification point $T_{mp}$ due to the impurity can be read from the liquidus line of the state diagram, the gradient of the liquidus line is substantially constant when the concentration of the impurity is almost several percent. Therefore, the solidification point $T_{mp}$ is expressed by the following relational expression where the concentration of the impurity element in the melt is Cm, the gradient of the liquidus line is m, and the solidification temperature of pure silicon is $T_{mp0}$ (1, 685 K) :

$$T_{mp} = T_{mp0} - mC_m$$

$$\cdots\cdots (19)$$

Here, it is known that the concentration $C_m$ of the impurity element in the melt in the middle of the solidification is expressed by an expression below using the initial concentration $C_0$ of the impurity element, the solidification rate g obtained from the height x of the solidification front, and the effective distribution coefficient $K_{eff}$. That is, the concentration $C_m$ of the impurity element in the melt is concentrated in association with solidification.

$$C_m = C_0(1-g)^{keff-1}$$

$$\cdots\cdots (20)$$

Consequently, the Tmp is described by the following expression:

$$T_{mp} = T_{mp0} - mC_0(1-g)^{keff-1}$$

$$\cdots\cdots (21)$$

Therefore, in the case where the concentration of the impurity is high and there is a need of considering a change in solidification point, it is desirable to use the following modified expression in which the Tmp is replaced with the expression (19):

$$VOGC = \frac{V}{G}C_m$$

$$= \frac{1}{\rho L}\left( J_b \frac{K_{m_0}}{K_m} \frac{K_m + (H-x)4\varepsilon\sigma T_a^3}{4\varepsilon\sigma T_a^3 \left(T_a - (T_{mp0} - mC_0(1-x/H)^{keff-1})\right)} - K_{m_0} \right)C_0(1-x/H)^{keff-1}$$

$$\cdots\cdots (22)$$

In view of the foregoing, in the present invention, the expression for calculating a compositional supercooling index (VOGC) is substantially given by the following expression (23):

$$VOGC = \frac{1}{\rho L}\left( J_b \frac{K_{m_0}}{K_m} \frac{K_m + (H-x)4\varepsilon\sigma T_a^3}{4\varepsilon\sigma T_a^3 \left(T_a - T_{mp}\right)} - K_{m_0} \right)C_0(1-x/H)^{keff-1}$$

$$\cdots\cdots (23)$$

The solidification height x in this expression can be calculated with an integral of the solidification velocity V over time when the solidification-starting time is 0.

$$x = \int_0^t V dt$$

$$\cdots\cdots (24)$$

Although the actual control of a furnace is automatically performed by the so-called programmable logic controller (PLC) device, the PLC device is able to calculate a VOGC value with the expression (25) given by discretization of the expression (24) from the integral value for each of control steps executed at predetermined time intervals. Here, in other words, when the order of steps is set to i, the height x of the solidification front after the step (i+1) from the control start is calculated as follows from the height of the solidification front and the solidification velocity after the step i, and the time interval between the step (i+1) and the step i:

$$\begin{cases} x_{i+1} = x_i + V_{(T_a,x,t)_i}(t_{i+1} - t_i) \\ x_0 = 0 \quad \text{at} \quad t_i = 0 \end{cases}$$

$$\cdots\cdots \quad (25)$$

Here, the value of the x may be calculated using the solidification velocity V expressed by the expression (14), or may be directly calculated using the means 10 for measuring the height of a solidification front.

It is understood from the foregoing that the value of the VOGC is calculated for each time $t_i$ by finally determining the heater radiation temperature for each time $t_i$, or heat pattern $T_a(t_i)$, by a numerical calculation method (method 1) or a solidification height measurement method (method 2).

By the way, the method 1 does not require the measurement of the height of the solidification front, and hence equipment can be simple. However, the calculated height x of the solidification front and the solidification velocity V may be different from the actual height x of the solidification front measured by the means 10 for measuring the height of a solidification front and the solidification velocity V calculated therefrom as a result of any of certain causes, such as solidification conditions which are still  unstable due to, for example, the operation of a new furnace and changes of inner furnace members, and a decrease in the flow rate of cooling water due to an equipment trouble. Then, in such case, it is possible to suppress a decrease in yield to the minimum by setting the actual measurement value of the height x of the solidification front to a positive value by the method 2 and performing real-time correction of the heater temperature to prevent the actual velocity from exceeding the critical value of the compositional supercooling.

Hereinafter, the procedures for calculating the VOGC are described with respect to the method 1 and the method 2, respectively.

(Method 1)

[Step 1] The concentration $C_m$ of the impurity element calculated from the expression (20) is substituted into the expression (21) to obtain the solidification interface temperature $T_i(=T_{mp})$.
[Step 2] The $T_i$ is substituted into the expressions (14) and (17) to obtain the solidification velocity V and the temperature gradient G on the melt side of the solidification interface.
[Step 3] The VOGC is calculated using the V, G, and $C_m$ obtained by Step 1 and Step 2.
[Step 4] The height x of a solidification front of the next time step is obtained from the solidification velocity V using the expression (25).
[Step 5] Subsequently, Step 1 to Step 4 are repeated to obtain the VOGC in each time $t_i$.

(Method 2)

[Step 1] The concentration $C_m$ of the impurity element calculated from the expression (20) is substituted into the expression (21) to obtain the solidification interface temperature $T_i(=T_{mp})$.
[Step 2] The solidification velocity V is obtained from the height x of the solidification front and the time variation thereof measured by the means 10 for measuring the height of a solidification front.
[Step 3] The $T_i$ and the x are substituted into the expression (17) to obtain the temperature gradient G on the melt side of the solidification interface.
[Step 4] The VOGC is calculated using the V, G, and $C_m$ obtained by Step 1 to Step 3.
[Step 5] Subsequently, Step 1 to Step 4 are repeated to obtain the VOGC in each time $t_i$.

Here, conditions that may differ for every solidification purification process include the initial concentration $C_0$ of the impurity element in the raw material, and the $J_b$ due to variations in the degree of contact between the cooling means 7 and the bottom 5b of the molds 5. Although conventional control techniques have paid attention only to variations in the initial concentration $C_0$ of the impurity element, it is found from the expression for analyzing the stationary one-order heat transfer that the $J_b$ affects a heat transfer phenomenon. The $J_b$ is significantly affected by the degree of contact between the cooling means 7 and the bottom 5b of the mold 5, and thus the $J_b$ significantly  affects the quality of a crystal obtained and the productivity thereof. Therefore, when the heater pattern is previously calculated with respect to several patterns of combination of the $C_0$ and $J_b$ so that the compositional supercooling index $\{ VOGC= (V/G) \times Cm\}$ satisfies the range of 1/10 or more of the critical value of the compositional supercooling and not more than the critical value, the optimal heater pattern for the solidification process can be selected from the actual $C_0$ value and the information about the $J_b$ immediately after the start of the solidification, and the process of solidification purification can be controlled at a solidification velocity near the maximum value that does not generate compositional supercooling. Further, the $J_b$ can be easily measured as a value obtained by dividing the heat flow rate measured with a calorimeter placed in cooling water for cooling the bottom of the mold by the area of the bottom of the crystal. In addition, the $J_b$ has a tendency of decreasing in substantial proportion to a solidification rate owing to the thermal resistance of the solid silicon accompanying an increase in solidification height.

The arithmetic processing ability of the recent PLC is able to complete the calculations used in the present invention within several seconds. Since the solidification velocity is comparatively slow, specifically several millimeters per minute or less, there is sufficient time for the control even after the recalculation of the heater pattern from the $J_b$ obtained in the operation even in the case where there is no heater pattern corresponding to the initially measured $J_b$. Similarly, further, as long as the insulation is completely maintained in the direction of the lateral sides of the mold, even when, for example, a change with time occurs in the heating means 6, the bottom 5b of the mold 5, or the cooling means 7, the process can be normally controlled in exactly the same way by only monitoring the temperature $T_a$ of the heating means and the heat flow rate $J_b$ escaping from the lower part structure 17 of the mold, which is calculated from the inlet temperature, outlet temperature, and flow rate of the cooling water 8.

EXAMPLE

(Example 1)

Unidirectional solidification purification of 350 kg of metallic silicon (containing iron as an impurity at a concentration of 2, 000 ppmw) provided as a solidification purification rawmaterial was performed by using a solidification purification device for a metallic silicon of FIG. 1 according to the example of the present invention. The mold 5 used in this Example 1 is a square-shaped container of 0.4 m in height including the side walls and bottom 5b thereof, and produces a crystal having a square cross-section of 0.8 m on side and 0.22 m in height.

Used as an effective thermal conductivity Km in the melt for calculating the VOGC value was the effective thermal conductivity of a silicon melt, 200 (W/m/K), actually measured as basic data in advance. Further, a value of 67 (W/m/K) determined by physical properties was used as a thermal conductivity $Km_0$ in the stationary melt. Further, 21 (W/m/K) was used as a thermal conductivity of an ingot. In addition, 0.3 was used as an effective radiation rate between a silicon melt and a heater. Further, an estimated required time from the start to completion of solidification was 15 hours (900 minutes).

In this Example 1, the VOGC value (predicted VOGC value) was calculated by the method of the present invention, and the radiation temperature of the heater was calculated and set so that the predicted VOGC value was not more than the critical value. An example of the setting (predicted heater temperature control pattern) is illustrated as a solid line in an upper stage of the graph of FIG. 3.

With respect to iron as an impurity element to be purified in this example 1, no experimentally obtained diffusion coefficient D thereof in a silicon melt has been reported, and no reliable value has been known. Thus, the critical value of compositional supercooling could not be predicted. In view of the foregoing, in the examination of solidification purification, which was carried out by the inventors of the present invention, by taking correspondence of the solidified structure and impurity concentration of the purified crystal with the operation process data, a value of $1.0 \times 10^{-1}\,m^2/K/sec$ was obtained as a critical value of compositional supercooling. This value was therefore used. This critical value is indicated by a thick dashed line in the middle of the graph of FIG. 3.

To predict the VOGC value in the solidification from the heater radiation temperature pattern which was set here, first, the heat flow rate $J_b$ escaping from the bottom of the mold is required. This can be obtained from the operation past results of the applicable furnace. Namely, in the operation of the furnace of this Example 1, it has already been known that: the flow rate of cooling water flowing in a cooling panel of the bottom of the mold is 150 L/min; the temperature difference between the inlet temperature and outlet temperature of the cooling water is 6.1°C at the initial stage of the solidification, decreases in proportion to a solidification rate, and reaches 4.3°C at the completion of the solidification; and there is 10% of detection loss in the measurement of heat flow rate in the cooling water in the cooling panel. This means that the quantity of heat escaping from the bottom of the mold decreases from 71 KW to 50 KW together with a decrease in solidification rate owing to heat quantity calculation. In addition, as the base area of the crystal is 0.64 $m^2$, the $J_b$ is 111 W/$m^2$ at the start of the solidification and 79 W/$m^2$ at the completion of the solidification. The value obtained by dividing the $J_b$ by the thermal conductivity of the crystal is the temperature gradient $G_s$ in the crystal. The value is indicated by a dense dashed line in the graph of the lower stage of FIG. 3.

The transition of the temperature gradient G in the melt is calculated by the expression (17), and this is indicated by a sparse dashed line in the graph of the lower stage of FIG. 3. In addition, the transition of the solidification velocity V is calculated by the expression (14), and this is indicated by a solid line in the lower stage of FIG. 3. Further, the transition of the concentration Cm of impurities in the melt is calculated by the expression (20) based on the initial concentration $C_0$ of impurities (= 2, 000 ppmw), and this is indicated by a dashed line in the graph on the middle stage of FIG. 3.

Although the transition of the VOGC value is calculated by the expression (1), the transition can be obtained from the temperature gradient G and solidification velocity V of the melt, and the concentration Cm of impurities in the melt by multiplying the V value and the Cm value at each time, and then dividing the product by the G value, and this is indicated by a solid line in the graph on the middle stage of FIG. 3. In the calculation here, further, the change of the solidification point in the melt is taken into consideration based on the expression (19), and, in the graph on the upper stage of FIG. 3, the change is indicated by a downside solid line (near 1,410°C). Further, the melt surface temperature Ts is calculated based on the expression (15), and, in the graph on the upper stage of FIG. 3, this is indicated by a dashed line.

As described above, the VOGC was calculated with reference to the control pattern of the heater radiation temperature, which was set in the Example 1. The obtained VOGC value is $1.3 \times 10^{-11}$ m2/K/sec at the time of the start of the solidification, and is larger than 1/10 of the critical value, a VOGC value of $1.0 \times 10^{-10}$ m2/K/sec. Although the VOGC increases gradually with time, the VOGC exceeds a critical value of $1.0 \times 10^{-10}$ m2/K/sec for the first time at a time of 830 minutes, which is near the time of the completion of the solidification, and subsequently the solidification is completed in a state where the VOGC is over the critical value. Further, a crystal solidification rate of 90% when the VOCG reaches the critical value is also calculated based on the expression (23).

Further, the descendent gradient of temperature after 830 minutes, the final stage of the solidification, is increased, and hence the solidification velocity increases, and the VOGC value exceeds the critical value and rapidly increases. This is because the solidification rate is almost 90% at the time near the time of solidification completion, and, even when the yield at this portion is decreased, productivity increases on the whole as the solidification velocity increases.

Therefore, when the operation of a solidification furnace is carried out based on the control pattern of the heater radiation temperature, which is set in the Example 1, the compositional supercooling of the melt does not occur during the period from the start of the solidification to a solidification rate of 90%. Thus, 90% of the ingot is solidified and purified, and hence the ingot of good quality can be obtained.

In actuality, the solidification purification of metallic silicon was performed according to the control pattern of the heater temperature of the upper stage of FIG. 3, and the center portion of the obtained silicon crystal was cut in a vertical (solidification) direction. Then, the change of the analytical concentration of an impurity in a height (solidification-advancing) direction of the cross- section was measured using a portable simple fluorescent X- ray device. Regarding the measurement points, the measurement was performed at eight points at 10 mm intervals in the height direction (solidification- advancing direction) of a crystal, and at 100 mm intervals in the horizontal direction (for the same solidification rate, a starting point was 50 mm apart from the outer peripheral position of the crystal in the horizontal direction. The number of the measurement points was 168 in total.

The results of the measurement are illustrated in FIG. 4.
In the graph of FIG. 4, the height of the crystal (solidification rate g) is indicated by the axis of abscissa, the VOCG value predicted thereto is indicated by a solid line, the critical value of the VOCG is indicated by a dashed-dotted line, and, in the height direction of the cross-section, the concentration of Fe provided as an average of eight points on the same height (same solidification rate) is indicated by a closed circle.

Although the concentration of Fe in the silicon crystal was not detected by a crystal height of 180 mm (solidification rate of 81%), and was 5 ppmw as the detection lower limit of the analyzer, the concentration started to be detected from a height of 190 mm (solidification rate of 85%) . The concentration was 14 ppmw at 190 mm, 16,400 ppmw at 200 mm (solidification rate of 890), 18,200 ppmw at 210 m (solidification rate of 93%), and 20,700 ppmw at 220 mm (solidification rate of 98%). Further, according to visual structural observation, a columnar crystal grew up to a position at a height of 205 mm (solidification rate of 90%) and then became an equiaxial crystal from 205 mm. Consequently, a crystal solidified and purified at a ratio of 90% or more was obtained by the control method described in the Example 1.

(Comparative Example 1)

In addition, as Comparative Example 1, further, the solidification purification was performed under the same conditions as those of the Example 1 by the use of the conventional control pattern of the heater radiation temperature, and also the use of the same device and the same solidification purification rawmaterial, metallic silicon, as those of the Example 1. This control pattern of the heater radiation control intends the following. As estimated required time from the start to completion of solidification is 15 hours (900 minutes), and in order to avoid rapid solidification in an early stage of the solidification, the descendent gradient of the temperature is set almost constant from the start of the solidification toward the middle thereof, and, in the latter half of the solidification, the heater radiation temperature is kept at high temperature for solidification purification. The VOGC value is also calculated under the conditions of this Comparative Example 1. The physical property value used and the change of the Jb in association with the advance of the solidification are the same as those of Example 1.

In this Comparative Example 1, an exemplary setting of the heater radiation temperature (predicted heater temperature control pattern) is indicated by a solid line on the upper side of the upper stage of the graph in FIG. 5. Here, the transition of the temperature gradient G in the melt is indicated by a sparse dashed line in the graph of the lower stage of FIG. 5. Inaddition, the transition of the solidificationvelocity V is indicated by a solid line in the graph of the lower stage of FIG. 5. Further, the transition of the concentration Cm of an impurity in the melt is indicated by a dashed line in the graph of the middle stage of FIG. 5. Further, the transition of the VOGC value is indicated by a solid line in the graph of the middle stage of FIG. 5. Further, the change of the solidification point is indicated by a lower solid line in the graph of the upper stage of FIG. 5. In addition, the temperature Ts of the surface of the melt is indicated by a dashed line in the graph of the upper stage of FIG. 5.

Thus, the VOGC was calculated with reference to the control pattern of the heater radiation temperature set in the Comparative Example 1. The obtained VOGC value is $7.2 \times 10^{-12}$ m²/K/sec at the time of the start of the solidification, and is smaller than 1/10 of the critical value, a VOGC value of $1.0 \times 10^{-10}$ m²/K/sec. It turns out that the solidification velocity has enough margins. Further, the VOGC increases gradually with time, and the VOGC exceeds a critical value of $1.0 \times 10^{-10}$ m²/K/sec at a time of 570 minutes from the start of the solidification and subsequently the solidification is completed in a state where the VOGC is over the critical value. Further, a crystal solidification rate of 60% when the VOCG reaches the critical value is also calculated based on the expression (23) .

Therefore, when the operation of a solidification furnace is carried out based on the control pattern of the heater radiation temperature, which is set in the Comparative Example 1, the compositional supercooling of the melt occurs during the period from the start of the solidification to a solidification rate of 60%. Thus, only about 60% of the ingot is solidified and purified.

In actuality, the solidification purification of metallic silicon was performed according to the control pattern of the heater temperature of the upper stage of FIG. 5, and, just as in the case with the Example 1, the center portion of the silicon crystal was cut in a vertical (solidification) direction. Then, the change of the analytical concentration of an impurity in a height (solidification- advancing) direction of the cross- section was similarly measured using a portable simple fluorescent X- ray analyzer. The measurement points were the same as those of the Example 1.

The results of the measurement are illustrated in FIG. 6. In this graph, the height of the crystal (solidification rate g) is indicated by the axis of abscissa, the VOCG value predicted thereto is indicated by a solid line, and, in the height direction of the cross-section, the value of the Fe concentration provided as an average of eight points on the same height (same solidification rate) is indicated by a closed circle.

Although the concentration of Fe in the ingot was not detected by a crystal height of 120 mm (solidification rate of 54%), and was 5 ppmw as the detection lower limit of the analyzer, the concentration started to be detected from a height of 130 mm (solidification rate of 58%). At 140 mm (solidification rate of 63%) or more, the high value exceeding 3,000 ppmw was observed. Further, according to visual structural observation, a columnar crystal grew up to a position at a height of 140 mm at a maximum and then became an equiaxial crystal from 140 mm. It was found from the foregoing that only about 60% of the raw material was able to be solidified and purified by the control method described in this comparative example.

Therefore, the conventional method cannot be sufficiently prepared for a change in rate of the heat flow from the lowerpart structure of the mold. In addition, the solidification velocity cannot be precisely controlled using the information about the solidification position obtained during the solidification. Thus, a decrease in yield may be caused by generation of a portion where the solidification velocity exceeds the critical value of the compositional supercooling during the latter half of the solidification.

(Example 2)

As Example 2, solidification purification of 350 kg of metallic silicon was performed using the same solidification purification device for a metallic silicon and the same mold as those of the Example 1, where the impurity concentration of a solidification purification raw material was 2, 500 ppmw, and the composition thereof included 1,200 ppmw of iron, 800 ppmw of aluminum, and 400 ppmw of nickel. Here, an estimated required time from the start to completion of the solidification was 15 hours (900 minutes).

In this Example 2, the VOGC value (predicted VOGC value) was calculated by the method of the present invention, and the radiation temperature of the heater was calculated and set so that the predicted VOGC value was not more than the critical value. An example of the setting (predicted heater temperature control pattern) is illustrated as a solid line in an upper stage of the graph of FIG. 7.

Since there are three kinds of impurities, iron, aluminum, and nickel, to be purified in this Example 2, the critical value of the VOGC value is given by the following expression in which the weight density of all the impurities is $C_{m-all}$ as described previously:

$$(V/G)C_{m-all} < 0.59 < D/m>$$

Here, $<D/m>$ is the reciprocal of the weighted harmonic average of the values $(m_i/D_i)$ of the respective impurity components taking $\alpha_i$ as a weight. Thus, the value of the $(m_i/D_i)$ is needed for each component. Here, for iron, $5.85 \times 10^9$ Ksec/m$^2$, which was the reciprocal of the value obtained by dividing a VOGC critical value of $1.0 \times 10^{-10}$ m$^2$/K/sec employed in the Example 1 by 0.59, was employed. Further, for aluminum, $1.43 \times 10^9$ Ksec/m, which was obtained from m=544°C/ 100 w% of the liquidus line gradient read from the status diagram and the literature diffusion coefficient D=$3.80 \times 10^{-7}$ m$^2$/s, was employed. Further, for nickel, $2.04 \times 10^9$ Ksec/m, which was obtained from m=214°C/ 100 wt% of the liquidus line gradient read from the status diagram and the literature diffusion coefficient D=$1.05 \times 10^{-7}$ m$^2$/s, was employed. Further, the weight ratios $\alpha_i$ of the impurities are 0.5 for iron, 0.33 for aluminum, and 0.17 for nickel. When those values are used, the value of the $<D/m>$ is set to $1.6 \times 10^{-10}$ m$^2$/K/sec, and the VOGC critical value is set to $9.3 \times 10^{-1}$ m$^2$/K/sec. This critical value is indicated by a thick dashed line in the middle stage of the graph of FIG. 7.

To predict the VOGC value in the solidification from the heater radiation temperature pattern which was set here, first, the heat flow rate $J_b$ escaping from the bottom of the mold is required. At the time of operation in this Example 2, the thermal contact resistance between the bottom of the mold and the water-cooling jacket was increased by time degradation of the furnace. Thus, the amount of cooling water flowing through the water-cooling jacket is 150 L/min, which was the same as that of the Example 1. The difference between the inlet temperature and outlet temperature of the cooling water was 5.7 °C at the early stage of the solidification, and was 4.3°C at the time of the completion of the solidification. This is calculated as follows: that heat removal from the bottom of the mold is decreased from 66 KW to 47 KW in association with the solidification rate, and the $J_b$ is 104 W/m$^2$ at the time of the start of the solidification and 74 W/m$^2$ at the time of the completion of the solidification. The value obtained by dividing the $J_b$ by the thermal conductivity of the crystal is the temperature gradient $G_s$ in the ingot. The value is indicated by a dense dashed line in the graph of the lower stage of FIG. 7.

In this Example 2, an exemplary setting of the heater radiation temperature (predicted heater temperature control pattern) is indicated by an upper solid line on the upper stage of the graph of FIG. 7. In this Example 2, the concentration of all the impurities is high and the $J_b$ is decreased by the time degradation of the bottom of the mold. Thus, the solidification purification in the Example 2 is under difficult conditions as compared with the Example 1. This setup aims to suppress the solidification velocity by increasing the gradient, through the decrease of the temperature of the early stage of the solidification as compared with the Comparative Example 1, to increase the solidification velocity at the early stage of the solidification, and setting the radiation temperature of the heater to a relatively high value at the final stage of the solidification.

Here, the transition of the temperature gradient G in the melt is indicated by a sparse dashed line in the graph of the lower stage of FIG. 7. In addition, the transition of the solidification velocity V is indicated by a solid line in the graph of the lower stage of FIG. 7. Further, the transition of the concentration Cm of impurities in the melt is indicated by a dashed line in the graph of the middle stage of FIG. 7. Further, the transition of the VOGC value is indicated by a dashed line in the graph of the middle stage of FIG. 7. Further, the change of the solidification point in the melt is indicated by a lower solid line in the graph of the upper stage of FIG. 7. In addition, the temperature Ts of the surface of the melt is indicated by a dashed line in the graph of the upper stage of FIG. 7.

The VOGC value, which was obtained with reference to the control pattern of the heater radiation temperature set in the Example 2, was $2.2 \times 10^{-11}$ m$^2$/K/sec at the time of the start of the solidification. After that, the VOGC increases gradually with time, the VOGC exceeds a critical value of $9.3 \times 10^{-11}$ m$^2$/K/sec at a time of 830 minutes from the start of the solidification, and subsequently the solidification is completed in a state where the VOGC exceeds the critical value. Further, a crystal solidification rate of 89% when the VOCG reaches the critical value is also calculated based on the expression (23).

Therefore, when the operation of a solidification furnace is carried out based on the control pattern of the heater radiation temperature, which is set in the Example 2, the solidification purification is carried out from the start of the solidification to a solidification rate of 90%, resulting in a good quality crystal.

In actuality, the solidification purification of metallic silicon was performed according to the control pattern of the heater temperature on the upper stage of FIG. 7. In a manner similar to the Example 1, the center portion of the silicon crystal was cut in a vertical (solidification) direction. Then, the change of the analytical concentration of an impurity in a height (solidification- advancing) direction of the cross- section was similarly measured using a portable simple fluorescent X- ray analyzer. The measurement points are the same as those of the Example 1.
The results of the measurement are shown in FIG. 8.

In the graph of FIG. 8, the height of the crystal (solidification rate g) is indicated by the axis of abscissa, the VOCG value predicted thereto is indicated by a solid line, and, in the height direction of the cross-section, the concentration of Fe is indicated by a closed circle, the concentration of aluminum is indicated by a triangle, and the concentration of nickel is indicated by x, each of which is provided as an average of eight points on the same height (same solidification rate).

Although the concentration of Fe in the silicon crystal was 5 ppmw as the detection lower limit of the analyzer by a crystal  height of 190 mm (solidification rate of 85%), the concentration started to be detected from a height of 200 mm (solidification rate of 89%). The concentration was 2,200 ppmw at 200 mm, 12,500 ppmw at 210 mm (solidification rate of 93%), and 15,100 ppmw at 220 mm (solidification rate of 98%).

In addition, although the concentration of aluminum was 10 ppmw as the detection lower limit of the analyzer by a crystal height of 190 mm (solidification rate of 85%), the concentration started to be detected from a height of 200 mm (solidification rate of 89%). The concentration was 5,400 ppmw at 200 mm, 7,900 ppmw at 210 mm (solidification rate of 93%), and 8,500 ppmw at 220 mm (solidification rate of 98%).

Further, although the concentration of nickel was 5 ppmw as the detection lower limit of the analyzer by a crystal height of 180 mm (solidification rate of 81%), the concentration started to be detected from a height of 190 mm (solidification rate of 85%) . The concentration was 45 ppmw at 190 mm, 4, 300 ppmw at 200 mm (solidification rate of 89%), 4, 600 ppmw at 210 m (solidification rate of 93%), and 5, 700 ppmw at 220 mm (solidification rate of 98%) .

Further, according to visual structural observation, a columnar crystal grew up to a position at a height of 205 mm (solidification rate of 90%) and then became an equiaxial crystal from 205 mm. Consequently, a crystal solidified and purified at a ratio of about 90% or more was obtained by the control method described in the Example 2.

Reference Signs List

1 ⋯ liquid phase (melt) of metallic silicon, 2 ⋯ a solid phase of the metallic silicon, 3 ⋯ the solidification interface between the liquid phase and solid phase of the metallic silicon, 4 ⋯ surface of a melt of the liquid phase (melt) of the metallic silicon, 5 ⋯ mold, 5b ⋯ bottom of the mold 5, 6 ⋯ electrical heater (heating means), 7 ⋯ water-cooling jacket (cooling means), 8 ⋯ cooling water, 9 ⋯ insulation means, 10 ⋯ means for measuring the height of a solidification front, 11 ⋯ means for temperature measurement, 12 ⋯ means for controlling a solidification velocity including means for calculating the quantity of heat removed from the bottom and means for compositional supercooling calculation, 13 ⋯ power source of the electrical heater, 14 ⋯ transmission means for transmitting information about the temperature of the heater, 15 ⋯ transmission means for transmitting information about the cooling water, 16 ⋯ transmission means for transmitting power control information for the power source of the electrical heater, 17 ⋯ lower part structure such as the bottom of the mold or the water-cooling jacket 7

**Claims**

1. A solidification purification method for a metallic silicon, in which a melt of metallic silicon in a mold of a solidification purification device is subjected to unidirectional solidification to remove an impurity element in the metallic silicon, the solidification purification method comprising:

   performing heating and/or cooling of the melt such that a compositional supercooling index {VOGC= (V/G) $\times$ Cm} expressed by using a temperature gradient G on a melt side of a solidification interface, a concentration Cm of the impurity element in the melt during the solidification, and a solidification velocity V maintains a relationship with a critical value {0.59 (D/m) } of compositional supercoiling expressed by using a gradient m of a liquidus line read from a state diagram of silicon- impurity element in the metallic silicon and a diffusion coefficient D of the impurity element, the relationship being expressed by the following expression.

   $$1/10\{0.59(D/m)\}\leq VOGC<0.59(D/m)$$

2. A solidification purification method for metallic silicon according to claim 1, wherein the unidirectional solidification of the melt in the mold is carried out by radiant heating from above a liquid surface of the melt while insulating lateral sides of the mold, and cooling from a bottom of the mold by removal of heat.

3. A solidification purification method for a metallic silicon according to claim 1 or 2, wherein, based on: information about physical properties of the metallic silicon, which includes solidification latent heat, a solidification point, a density, and a thermal conductivity; initial information related to the melt before the solidification, which includes an initial concentration of the impurity element and an initial depth of the melt; and time-series information during the solidification, which includes a heat flow rate of removal of heat from a crystal to an outside and a height of a solidification front,

the compositional supercooling index (VOGC) is given by calculating a product of the temperature gradient G on the melt side of the solidification interface and the solidification velocity V by using a balance of steady one-dimensional heat transfer through the solidification interface in a solidifying direction, and multiplying the product by the value Cm of the concentration of the impurity element in the melt.

4. A solidification purification method for a metallic silicon according to claim 3, wherein,

based on: the information about physical properties of the metallic silicon, which includes L: solidification latent heat, $T_{mp}$: a solidification point of silicon, p: a crystal density at the solidification point, and $K_{mo}$: a thermal conductivity of the stationarymelt; information about an effective thermal conductivity in the melt determined in advance, which includes $K_m$: an effective thermal conductivity in the melt; the initial information related to the melt before the solidification, which includes $C_o$: an initial concentration of the impurity element and H: an initial depth of the melt; and the time-series information during the solidification, which includes $J_b$: a heat flow rate of removal of heat from a bottom of a container to an outside and x: a height of a solidification front,

the compositional supercooling index (VOGC) is given by calculating the balance of steady one-dimensional heat transfer through the solidification interface in a solidifying direction by the following expression (1):

$$VOGC = \frac{1}{\rho L}\left( J_b \frac{K_{m_0}}{K_m} \frac{K_m + (H-x)4\varepsilon\sigma T_a^{\ 3}}{4\varepsilon\sigma T_a^{\ 3}\left(T_a - T_{mp}\right)} - K_{m_0} \right) C_0 (1-x/H)^{keff-1}$$

$$\cdots\cdots \quad (1)$$

where $T_a$ represents a radiation temperature of a heater, represents an effective radiation rate between the melt surface and the heater, $\sigma$ represents a Stefan-Boltzmann constant, and $k_{eff}$ represents an effective distribution coefficient.

5. A solidification purification device for a metallic silicon, which is configured to heat a melt of metallic silicon in a mold of the device by heat radiation from above a liquid surface of the melt, and cool the melt from a bottom of the mold by removal of heat, thereby carrying out unidirectional solidification of the melt in the mold to remove an impurity element in the metallic silicon, the solidification purification device comprising:

heating means which comprises a heater disposed above the liquid surface of the melt and configured to heat the liquid surface;
cooling means for cooling the bottom of the mold;
insulation means disposed on lateral sides of the mold and configured to insulate the lateral sides of the mold;
means for calculating a height of a solidification front, which is configured to calculate a solidification velocity V expressed by the following expression (0) from an initial stage of the solidification in chronological order,

$$V = \frac{1}{\rho L}\left( J_b - K_m \frac{4\varepsilon\sigma T_a^{\ 3}\left(T_a - T_i\right)}{K_m + (H-x)4\varepsilon\sigma T_a^{\ 3}} \right)$$

$$\cdots\cdots \quad (0)$$

and calculate a time-series height x of the solidification front by accumulative calculation from the calculated time-series solidification velocity;
means for temperature measurement, which is configured to measure a temperature $T_a$ of the heater in chronological order;
means for calculating a quantity of heat removed from the bottom, which is configured to measure an inlet temperature, outlet temperature, and flow rate of cooling water in the water-cooling jacket are measured in chronological order, and a heat flow rate $J_b$ removed from the bottom of the container to an outside is calculated from values obtained from the measurement;

means for computing a compositional supercooling index, into which information about physical properties of the metallic silicon, which includes L: solidification latent heat, $T_{mp}$: a solidification point of pure silicon, p: a density at the solidification point, and $K_{mo}$: thermal conductivity of the stationary melt, information about an effective thermal conductivity in the melt determined in advance, which includes Km: effective thermal conductivity in the melt, and initial information related to the melt before the solidification, which includes $C_0$: an initial concentration of the impurity element and H: an initial depth of the melt, are input, and also time-series information about the height x of the solidification front obtained by the means for calculating a height of a solidification front and time-series information about the heat flow rate $J_b$ removed from the bottom of the container to the outside, calculated by the means for calculating the quantity of heat removed from the bottom are input, and

which is configured to calculate a compositional supercooling index (VOGC) based on the input information by the following expression (1):

$$VOGC = \frac{1}{\rho L}\left( J_b \frac{K_{m_0}}{K_m} \frac{K_m + (H-x)4\varepsilon\sigma T_a^{\ 3}}{4\varepsilon\sigma T_a^{\ 3}\left(T_a - T_{mp}\right)} - K_{m_0} \right) C_0 \left(1 - x/H\right)^{keff-1}$$

$$\cdots\cdots\quad (1)$$

; and

means for controlling the temperature of the heater, which is configured to adjust the temperature of the heater depending on progress of the solidification of the melt so that the value of the compositional supercooling index (VOGC) calculated by the means for computing a compositional supercooling index maintains a relationship with a critical value {0.59 (D/m) } of compositional supercooling expressed by using a gradient m of a liquidus line, which is read from a state diagram of silicon- impurity element in the metallic silicon, and a diffusion coefficient D of the impurity element, the relationship being expressed as follows:

$$1/10\{0.59(D/m)\} \leqq VOGC < 0.59(D/m).$$

6.    A solidification purification device for a metallic silicon according to claim 5, further comprising, instead of the means for calculating a height of a solidification front, means for measuring a height of a solidification front which is configured to measure the height of the solidification front in chronological order, wherein,

instead of the time-series information about the height of the solidification front obtained by the means for calculating a height of a solidification front, time-series information about the height of the solidification front obtained by the means for measuring a height of a solidification front is input into the means for computing a compositional super-cooling index.

FIG. 1

FIG. 2

FIG. 3

FIG. 4

FIG. 5

FIG. 6

FIG. 7

FIG. 8

## INTERNATIONAL SEARCH REPORT

| | International application No. |
|---|---|
| | PCT/JP2011/076270 |

**A. CLASSIFICATION OF SUBJECT MATTER**
*C01B33/037*(2006.01)i

According to International Patent Classification (IPC) or to both national classification and IPC

**B. FIELDS SEARCHED**

Minimum documentation searched (classification system followed by classification symbols)
C01B33/00-33/46

Documentation searched other than minimum documentation to the extent that such documents are included in the fields searched
    Jitsuyo Shinan Koho      1922-1996   Jitsuyo Shinan Toroku Koho   1996-2012
    Kokai Jitsuyo Shinan Koho  1971-2012   Toroku Jitsuyo Shinan Koho   1994-2012

Electronic data base consulted during the international search (name of data base and, where practicable, search terms used)
    JSTPlus(JDreamII), JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| A | JP 2006-273628 A (Kyocera Corp.), 12 October 2006 (12.10.2006), entire text (Family: none) | 1-6 |
| A | JP 10-251009 A (Kawasaki Steel Corp.), 22 September 1998 (22.09.1998), entire text (Family: none) | 1-6 |
| A | JP 10-120493 A (Kawasaki Steel Corp.), 12 May 1998 (12.05.1998), entire text (Family: none) | 1-6 |

☒ Further documents are listed in the continuation of Box C.     ☐ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search <br>    25 January, 2012 (25.01.12) | Date of mailing of the international search report <br>    07 February, 2012 (07.02.12) |
|---|---|
| Name and mailing address of the ISA/ <br>    Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/076270

| C (Continuation). | DOCUMENTS CONSIDERED TO BE RELEVANT | |
|---|---|---|
| Category* | Citation of document, with indication, where appropriate, of the relevant passages | Relevant to claim No. |
| A | JP 10-182137 A (Kawasaki Steel Corp.),<br>07 July 1998 (07.07.1998),<br>entire text<br>(Family: none) | 1-6 |
| A | JP 2006-027940 A (Sharp Corp.),<br>02 February 2006 (02.02.2006),<br>entire text<br>& US 2008/0289150 A1 & EP 1777303 A1<br>& WO 2006/006436 A1 & CN 101018877 A | 1-6 |

Form PCT/ISA/210 (continuation of second sheet) (July 2009)

## REFERENCES CITED IN THE DESCRIPTION

**Patent documents cited in the description**

- JP 10120493 A

- JP 10182137 A

**Non-patent literature cited in the description**

- **HIDEO NAKAE.** Crystal Growth and Solidification. Agne Shofu Publishing Inc, 1998
- **W. KURZ ; D. J. FISHER.** Fundamental of Solidification. Trans Tech Publication, 1998
- **M. C. FLEMINGS.** Solidification Processing. McGraw Hill, 1974

- **TAN et al.** *JOM,* 2009, vol. 61 (1), 49
- **LIU et al.** *Scripta Materialia,* 2006, vol. 55, 367
- **M. AZIZI et al.** Ultrasound Measurement of the Position of the Growing Interface During Directional Solidification of Silicone. *25th EU-PVSEC proceedings, 2CV.,* 2010, vol. 1, 13